# EUROPEAN PATENT APPLICATION

(11) **EP 4 804 406 A1**
(43) Date of publication of application: **09.09.2026**
(21) Application number: 26158289.4
(22) Date of filing: 12.02.2026
(51) Int. Cl.: H03K 17/082, H01H 9/54, H02H 3/087

(54) **REDUCING AN OPEN CIRCUIT BREAKER VOLTAGE OF A DIRECT CURRENT (DC) SOLID-STATE OR SEMICONDUCTOR-BASED CIRCUIT BREAKER**

(30) Priority: 04.03.2025 US 202519069460
(71) Applicant: Siemens Industry, Inc., Alpharetta, Georgia 30005-4437 (US)
(72) Inventor: YANG, Guang, Peachtree Corners, GA, 30092 (US)
(74) Representative: Isarpatent

(57) **Abstract**

A solid-state circuit breaker is configured to reduce an open circuit breaker voltage in a way to lower a load side voltage at a Standby state without increasing On state power loss. It comprises an integral airgap in series with main power electronics components, at least one of a pull-down resistor or a pull-down resistance as a parasitic resistance, and standby switching components. It has four possible states of operation including On, Off, Trip and Standby states. The pull-down resistor and the standby switching components are configured to reduce the open circuit breaker voltage. In the On state, when the main power electronics components are On, the standby switching components are turned Off so no current can flow through the pull-down resistor. In the Standby state when the main power electronics components are Off, the standby switching components are turned On, the pull-down resistor can lower a load side voltage.

## Description

### BACKGROUND

### 1. Field

Aspects of the present disclosure generally relate to reducing an open circuit breaker voltage of a Direct Current (DC) solid-state or semiconductor-based circuit breaker.

### 2. Description of the Related Art

Solid-state circuit breakers have attracted much attention recently, largely due to their inherent advantages in controllability, interruption capabilities in DC distribution networks and fast and arc-free interruptions. A solid-state circuit breaker (SSCB) is a power distribution device that uses semiconductors and software to interrupt electric current. SSCBs are faster, more compact, and more reliable than traditional circuit breakers. SSCBs use semiconductor devices like MOSFETs and IGBTs to control the flow of current. They can detect and respond to faults in microseconds, while traditional circuit breakers operate in milliseconds. SSCBs can interrupt extreme currents without releasing energy, which reduces the risk of arc flash.

SSCBs have a faster response so they can detect and respond to faults much faster than traditional circuit breakers. SSCBs are more compact as they are smaller and lighter than traditional circuit breakers. SSCBs are more reliable than traditional circuit breakers. SSCBs are more efficient as they can be more energy efficient than traditional circuit breakers. SSCBs are safer as they can reduce the risk of arc flash. SSCBs are used in energy storage systems, electric vehicles, and renewable energy systems. They can also be integrated into smart grids and other intelligent power distribution systems.

A solid-state circuit breaker has three possible states of operation including an On state, an Off state and a Standby state. In the Standby state, power electronics of a solid-state circuit breaker act like resistors. When a voltage is applied across them, small amounts of current is allowed to flow, also known as a leakage current. Many standards have limits for such leakage current, so they don't reach harmful level. However, in DC distribution networks, capacitors are commonly used as part of the loads. Even if the leakage current is small, the capacitor can still be charged up and create high voltage at a load side of the breaker. If such charged capacitors are not addressed, electrical shock or other hazardous conditions may occur.

Therefore, a way to lower a load side voltage in a solid-state circuit breaker at a standby state without increasing on state power loss is needed.

### SUMMARY

Briefly described, aspects of the present disclosure relate to a way to lower a load side voltage in a solid-state circuit breaker at a standby state without increasing on state power loss. This concept is suitable for either a bidirectional or unidirectional DC solid-state circuit breaker. A DC solid-state or semiconductor-based circuit breaker has at least three possible states of operation including an On state, an Off state and a Standby state. According to several regulatory standards, a solid-state circuit breaker must have an integral airgap in series with the main power electronics components, which is an example of DC solid-state circuit breaker. With this construction, there are three possible states. On state is when the airgap is closed and power electronics are turned on, and current flows to the loads. Off state is when airgap is open and power electronics are turned off. No current flows, and isolation is achieved. Standby state is when airgap is closed, and power electronics are turned off. In standby state, load current is turned off and the solid-state circuit breaker is highly controllable, as load current can be turned on/off by simply toggle power electronics gate signal. In standby state, the power electronics are acting like resistors. When voltage is applied across them, small amounts of current is allowed to flow, also known as leakage current. Many standards have limits for such leakage current, so they don't reach harmful level. However, in DC distribution networks, capacitors are commonly used as part of the loads. Even if the leakage current is small, the capacitor can still be charged up and create high voltage at load side of the breaker. If such charged capacitors are not addressed, electrical shock or other hazardous conditions may occur. Therefore, it is important to lower the load side voltage to a safe level and to not allow the capacitors to charge. A common way of lowering the voltage is to have a pull-down resistor between the load side and the common. This way, the leakage current can go through the pull-down resistor and lower the load side voltage. A significant drawback is that in on state, the system voltage is directly across the pull-down resistor and can create a lot of power loss.

In accordance with one illustrative embodiment of the present disclosure, a Direct Current (DC) solid-state or semiconductor-based circuit breaker is described. The DC solid-state or semiconductor-based circuit breaker comprises an integral airgap in series with main power electronics components, a pull-down resistor, and standby switching components placed in series with the pull-down resistor. The DC solid-state or semiconductor-based circuit breaker has three possible states of operation including an On state, an Off state and a Standby state. A combination of the pull-down resistor and the standby switching components is configured to reduce an open circuit breaker voltage. The Standby state uses the pull-down resistor together with the standby switching components, The On state uses the pull-down resistor together with the standby switching components. In the On state, when the main power electronics components are On, the standby switching components are turned Off, as a result, no current can flow through the pull-down resistor. In the Standby state, when the main power electronics components are Off, the standby switching components are turned On, the pull-down resistor can lower a load side voltage.

In accordance with one illustrative embodiment of the present disclosure, a method to reduce an open circuit breaker voltage of a Direct Current (DC) solid-state or semiconductor-based circuit breaker is provided. The method comprises providing an integral airgap in series with main power electronics components, providing a pull-down resistor, and providing standby switching components placed in series with the pull-down resistor. The DC solid-state or semiconductor-based circuit breaker has three possible states of operation including an On state, an Off state and a Standby state. A combination of the pull-down resistor and the standby switching components is configured to reduce an open circuit breaker voltage. The Standby state uses the pull-down resistor together with the standby switching components, The On state uses the pull-down resistor together with the standby switching components. In the On state, when the main power electronics components are On, the standby switching components are turned Off, as a result, no current can flow through the pull-down resistor. In the Standby state, when the main power electronics components are Off, the standby switching components are turned On, the pull-down resistor can lower a load side voltage.

In another embodiment, a Direct Current (DC) solid-state or semiconductor-based circuit breaker comprises an integral airgap in series with main power electronics components, at least one of a pull-down resistor or a pull-down resistance as a parasitic resistance and standby switching components placed in series with the pull-down resistor. The DC solid-state or semiconductor-based circuit breaker has an On state, an Off state, a Trip state and a Standby state. A combination of the pull-down resistor and the standby switching components is configured to reduce an open circuit breaker voltage. In the On state, when the main power electronics components are On, the standby switching components are turned Off, as a result, no current can flow through the pull-down resistor. In the Standby state, when the main power electronics components are Off, the standby switching components are turned On, the pull-down resistor can lower a load side voltage.

The above-described features and advantages, as well as others, will become more readily apparent to those of ordinary skill in the art by reference to the following detailed description and accompanying drawings. While it would be desirable to provide one or more of these or other advantageous features, the teachings disclosed herein extend to those embodiments which fall within the scope of the appended claims, regardless of whether they accomplish one or more of the above-mentioned advantages.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects.

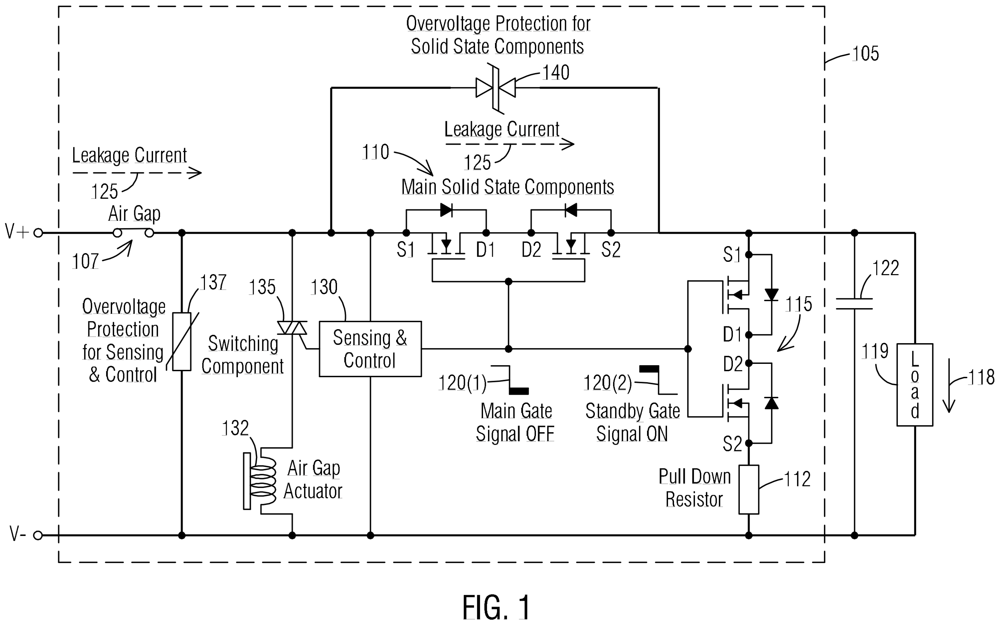

FIG. 1 illustrates a block diagram of a DC circuit breaker, which in a standby state uses a pull-down resistor together with standby switching components to lower a load side voltage in a solid-state circuit breaker such as a DC circuit breaker at the standby state without increasing on state power loss in accordance with one or more embodiments of the present disclosure.

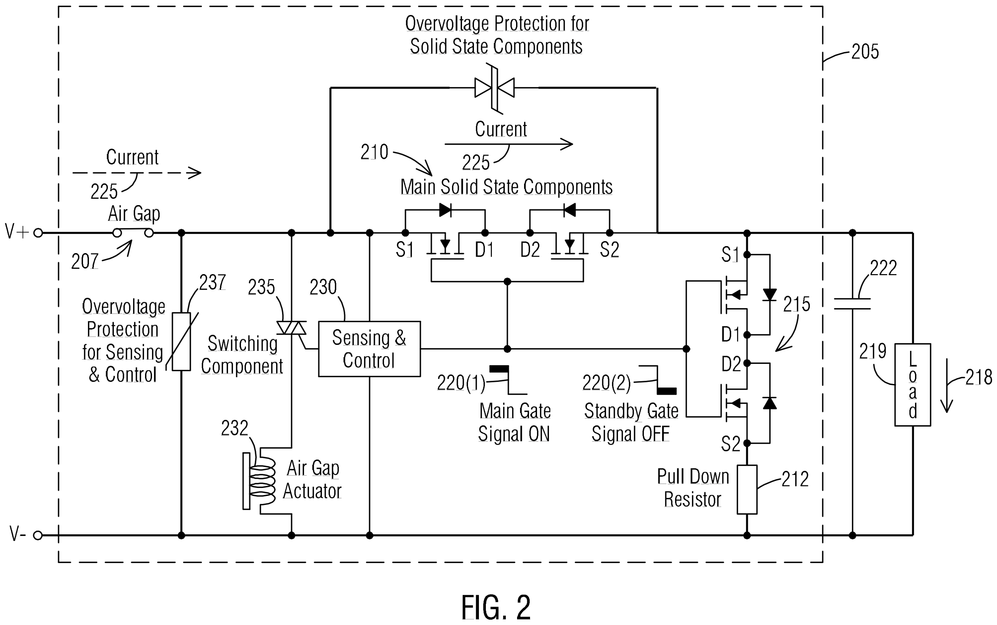

FIG. 2 illustrates a block diagram of a DC circuit breaker having an on state that uses a pull-down resistor together with standby switching components for reducing an open circuit breaker voltage of a Direct Current (DC) solid-state or semiconductor-based circuit breaker in accordance with an embodiment of the present disclosure.

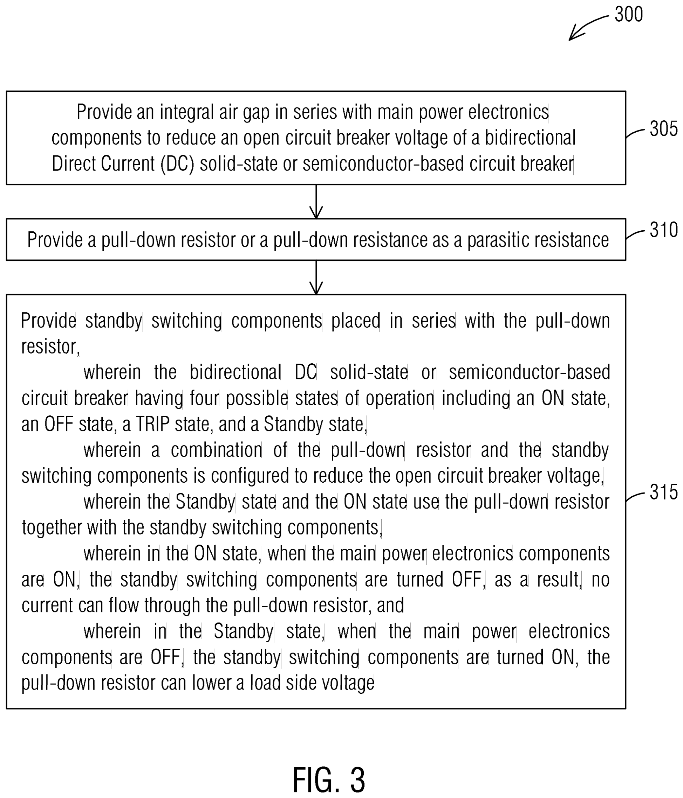

FIG. 3 illustrates a schematic view of a flow chart for a method of reducing an open circuit breaker voltage of a Direct Current (DC) solid-state or semiconductor-based circuit breaker according to an embodiment of the present disclosure.

### DETAILED DESCRIPTION

Various technologies pertain to a way that provides to lower a load side voltage in a solid-state circuit breaker at a standby state without increasing on state power loss. The drawings discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged apparatus. It is to be understood that functionality that is described as being carried out by certain system elements may be performed by multiple elements. Similarly, for instance, an element may be configured to perform functionality that is described as being carried out by multiple elements. The numerous innovative teachings of the present application will be described with reference to exemplary non-limiting embodiments.

To facilitate an understanding of embodiments, principles, and features of the present disclosure, they are explained hereinafter with reference to implementation in illustrative embodiments. In particular, they are described in the context of a way to lower a load side voltage in a solid-state circuit breaker at a standby state without increasing on state power loss. Embodiments of the present disclosure, however, are not limited to use in the described systems or methods.

The components and materials described hereinafter as making up the various embodiments are intended to be illustrative and not restrictive. Many suitable components and materials that would perform the same or a similar function as the materials described herein are intended to be embraced within the scope of embodiments of the present disclosure.

These and other embodiments of the system are provided for a way to lower a load side voltage in a solid-state circuit breaker at a standby state without increasing on state power loss according to the present disclosure are described below with reference to FIGs. 1-3 herein. The drawings are not necessarily drawn to scale.

Consistent with an embodiment of the present disclosure, FIG. 1 represents a way to lower a load side voltage in a solid-state circuit breaker at a standby state without increasing on state power loss. A Direct Current (DC) solid-state or semiconductor-based circuit breaker 105 comprises an integral airgap 107 in series with main power/solid-state electronics components 110 and a pull-down resistor 112 or a pull-down resistance as a parasitic resistance being an unwanted resistance or an unintended resistance that exists within electronic components and circuits due to their physical properties and construction. The parasitic resistance may be caused by resistance of a supply source and/or an internal resistance of components like capacitors, inductors, and transistors and/or resistance of wires, and/or resistance of traces on a printed circuit board (PCB). The circuit breaker 105 further comprises standby switching components 115, including at least one of semiconductor components, relays or mechanical devices, placed in series with the pull-down resistor 112. The standby switching components 115 are electronic components such as metal-oxide-semiconductor field-effect transistors (MOSFETs) which control conductivity, or how much electricity can flow, between its source and drain terminals based on an amount of voltage applied to its gate terminal and are used as switches and amplifiers in an electronic circuit, however, they can be mechanical switches as well.

The Direct Current (DC) solid-state or semiconductor-based circuit breaker 105 is an advanced type of circuit breaker that uses semiconductor components instead of mechanical parts to interrupt the flow of electricity. Solid-state circuit breakers have some key features and benefits. Solid-state circuit breakers can detect and interrupt faults in microseconds, which is significantly faster than traditional mechanical circuit breakers. They rely on semiconductors, which means there are no mechanical components that can wear out over time. Because they don't produce arcs when interrupting current, the risk of dangerous arc flashes is minimized. These breakers have lower power losses during operation compared to traditional breakers. They offer advanced diagnostics, monitoring, and remote-control capabilities, making them suitable for modern smart grids and industrial applications. Solid-state circuit breakers are particularly useful in applications requiring high reliability and fast response times, such as renewable energy systems and industrial energy storage.

The integral airgap 107 in the solid-state or semiconductor-based circuit breaker 105 is a feature that provides physical separation within the circuit to ensure complete electrical isolation when the breaker 105 is in the "OFF" position. This is particularly important for safety and reliability. The airgap 107 ensures that there is no electrical continuity between the input and output terminals, providing true galvanic isolation. By physically separating the circuit, the airgap 107 helps prevent accidental re-energization and ensures that maintenance can be performed safely. Some circuit breakers combine solid-state components with an airgap 107 to leverage the fast-switching capabilities of semiconductors while ensuring complete isolation through the airgap 107. This combination of solid-state technology and an integral airgap 107 is often used in advanced power distribution systems to enhance both performance and safety.

The solid-state or semiconductor-based circuit breaker 105 incorporates several key power and solid-state electronics components as the main power/solid-state electronics components 110 to ensure efficient and reliable operation. For example, Power Semiconductor Devices as the core switching elements control the flow of current. Common types include Insulated Gate Bipolar Transistors (IGBTs) known for their high efficiency and fast switching capabilities, Metal-Oxide-Semiconductor Field-Effect Transistors (MOSFETs) used for their low on-resistance and high-speed switching, Silicon Carbide (SiC) Transistors which offer superior performance in terms of efficiency and thermal management, Gate Driver Circuit which provides the necessary voltage and current to switch the power semiconductor devices on and off efficiently. It ensures proper timing and coordination of the switching actions, Control Unit being typically a microcontroller or digital signal processor (DSP). The control unit monitors circuit parameters such as current, voltage, and temperature. It makes real-time decisions to open or close the circuit breaker based on predefined thresholds and conditions, Current and Voltage Sensors that measure the electrical parameters in the circuit. The data collected is used by the control unit to detect faults like overcurrent, short circuits, or overvoltage conditions, Heat Sink or Cooling System as power semiconductor devices generate heat during operation, so an effective cooling system is essential to maintain optimal performance and prevent overheating, Communication and Safety Devices which enable remote-control, diagnostics, monitoring, and integration with other protection and control devices in the power system. These components work together to provide fast, reliable, and efficient protection for electrical systems, making solid-state circuit breakers a valuable advancement in power distribution technology.

The pull-down resistor 112 is a resistor used in the solid-state or semiconductor-based circuit breaker 105 to ensure that a given pin or signal line is pulled to a low logical level (usually ground) when no other active device is driving the line. The pull-down resistor 112 prevents floating inputs, which can lead to unpredictable behavior. By connecting the pin to ground through a resistor, the pin is held at a defined low logic level when not actively driven high. The value of the pull-down resistor 112 is chosen to be high enough to avoid excessive current draw when the pin is driven high, but low enough to ensure the pin is reliably pulled to ground when not driven. While pull-down resistors pull the signal to ground, pull-up resistors pull the signal to a high logical level (usually the supply voltage) when no active device is driving the line.

In the solid-state or semiconductor-based circuit breaker 105, the standby switching components 115 are crucial for ensuring reliable operation and protection. These are the primary switching elements that control the flow of current. For example, Power Semiconductor Devices as the core switching elements control the flow of current.

The circuit breaker 105 generally or typically has four possible states of operation including an On state, an Off state, a Trip state and a Standby state. A combination of the pull-down resistor 112 and the standby switching components 115 is configured to reduce an open circuit breaker voltage. The open circuit breaker voltage of the solid-state circuit breaker 105 refers to the voltage present across the breaker terminals when it is in the "open" or "off" state, meaning no current is flowing through the circuit. This voltage is essentially the same as the supply voltage of the circuit being protected, as the breaker 105 is designed to completely isolate the load from the power source when it trips. In practical terms, the open circuit breaker voltage is important because it determines the insulation and dielectric requirements of the circuit breaker 105 to ensure it can safely handle the voltage without breaking down or causing unintended conduction.

The Standby state uses the pull-down resistor 112 together with the standby switching components 115. The On state uses the pull-down resistor 112 together with the standby switching components 115. In the On state, when the main power/solid-state electronics components 110 are On, the standby switching components 115 are turned Off, as a result, no current can flow through the pull-down resistor 112. In the Standby state when the main power/solid-state electronics components 110 are Off, the standby switching components 115 are turned On, the pull-down resistor 112 can lower a load side voltage. The load side voltage of the solid-state circuit breaker 105 refers to the voltage present on the side of the circuit breaker 105 that is connected to a load 119 (the devices or systems being powered). When the circuit breaker 105 is in the "closed" or "on" position, the load side voltage should be approximately equal to the supply voltage, assuming minimal voltage drop across the breaker itself. During normal operation, the load side voltage is essentially the same as the supply voltage, allowing the load to receive the necessary power. If a fault occurs and the circuit breaker 105 trips, the load side voltage will drop to zero or near zero, as the breaker 105 isolates the load 119 from the power source. Monitoring the load side voltage can help in diagnosing issues and ensuring that the load 119 is receiving the correct voltage for proper operation.

In the circuit breaker 105, the On state is when the integral airgap 107 is closed and the main power/solid-state electronics components 110 are turned On, and current flows to loads. By adding the standby switching components 115 and controlling them accordingly, the circuit breaker 105 can avoid power loss at the On state but still achieve a safe load side voltage. In the circuit breaker 105, the Off state is when the integral airgap 107 is open and the main power/solid-state electronics components 110 are turned Off no current flows, and isolation is achieved. In the circuit breaker 105, the Standby state is when the integral airgap 107 is closed, and the main power/solid-state electronics components 110 are turned Off such as in the Standby state, a load current 118 of the load 119 is turned Off and the circuit breaker 105 is highly controllable as the load current 118 can be turned On/Off by simply a toggle power electronics main gate signal 120(1). A standby gate signal 120(2) may be applied to the standby switching components 115. In the Standby state, when the main power/solid-state electronics components 110 are Off, the standby switching components 115 are turned On, and the pull-down resistor 112 can allow an already charged capacitor 122 to discharge.

In the circuit breaker 105, in the Standby state, the main power electronics components 110 are acting like resistors such that when a voltage is applied across them then small amounts of current is allowed to flow as a leakage current 125. Many industry standards have limits for the leakage current 125 so they don't reach a harmful level, however, in a DC distribution network, one or more capacitors are used as a part of loads. Even if the leakage current 125 is small, the capacitor 122 can still be charged up and create a high voltage at a load side of the circuit breaker 105 such that lowering of the load side voltage to a safe level is needed to not allow the capacitor 122 to charge and a way of lowering the load side voltage is to have the pull-down resistor 112 between the load side and a common. The leakage current 125 can go through the pull-down resistor 112 and lower the load side voltage. A significant drawback is that in the On state a system voltage is directly across the pull-down resistor 112 and can create a lot of power loss so this solution provides a way to lower the load side voltage at the Standby state without increasing the On state power loss.

The circuit breaker 105 further comprises a sensing and control unit 130, an air gap actuator 132, a switching component 135, an overvoltage protection 137 for the sensing and control unit 130 and an overvoltage protection 140 for solid-state components.

The sensing and control unit 130 of the solid-state circuit breaker 105 is a critical component that ensures the breaker 105 operates efficiently and reliably. The sensing and control unit 130 includes Current and Voltage Sensors to continuously monitor the electrical parameters of the circuit, such as current and voltage levels. They provide real-time data to the control unit 130, enabling it to detect faults like overcurrent, short circuits, or overvoltage conditions. It further includes a Microcontroller or Digital Signal Processor (DSP) being the brain of the control unit 130. It processes the data from the sensors and makes real-time decisions to open or close the circuit breaker 105 based on predefined thresholds and conditions. The microcontroller can also handle advanced functions like diagnostics, monitoring, and communication with other systems. The sensing and control unit 130 further includes a Gate Driver Circuit which provides the necessary voltage and current to switch the power semiconductor devices (such as IGBTs or MOSFETs) on and off efficiently. It ensures proper timing and coordination of the switching actions.

The sensing and control unit 130 further includes a Communication Interface which allows the control unit 130 to communicate with external systems for remote monitoring, diagnostics, and control. It can include interfaces like Bluetooth, Wi-Fi, or other industrial communication protocols. The control unit 130 runs Protection Algorithms that determine the appropriate response to various fault conditions. These algorithms ensure that the circuit breaker 105 trips quickly and accurately to protect the electrical system. Memory Components store configuration settings, fault logs, and other critical data. Non-volatile memory types like Flash or EEPROM are commonly used to retain information even when the power is off. Together, these components enable the solid-state circuit breaker 105 to provide fast, reliable, and intelligent protection for electrical systems.

FIG. 2 illustrates a block diagram of a Direct Current (DC) solid-state or semiconductor-based circuit breaker 205 having an On state that uses a pull-down resistor 212 together with standby switching components 215 for reducing an open circuit breaker voltage of the Direct Current (DC) solid-state or semiconductor-based circuit breaker 205 in accordance with an embodiment of the present disclosure.

The Direct Current (DC) solid-state or semiconductor-based circuit breaker 205 comprises an integral airgap 207 in series with main power/solid-state electronics components 210 and a pull-down resistor 212. The circuit breaker 205 further comprises standby switching components 215 placed in series with the pull-down resistor 212. The circuit breaker 205 further comprises a sensing and control unit 230, an air gap actuator 232, a switching component 235, an overvoltage protection 237 for the sensing and control unit 230 and an overvoltage protection 240 for solid-state components. A load current 218 flows through a load 219. A current 225 flows through the circuit.

A toggle power electronics main gate signal 220(1) may be applied to the main power/solid-state electronics components 210. A standby gate signal 220(2) may be applied to the standby switching components 215.

FIG. 3 illustrates a schematic view of a flow chart for a method 300 of reducing an open circuit breaker voltage of the Direct Current (DC) solid-state or semiconductor-based circuit breaker 105 according to an embodiment of the present disclosure. Reference is made to the elements and features described in FIGs. 1-2. It should be appreciated that some steps are not required to be performed in any particular order, and that some steps are optional.

The method 300 comprises a step 305 of providing an integral airgap in series with main power electronics components. The method 300 further comprises a step 310 of providing a pull-down resistor. The method 300 further comprises a step 315 of providing standby switching components placed in series with the pull-down resistor. The DC solid-state or semiconductor-based circuit breaker 105 has three possible states of operation including an On state, an Off state and a Standby state.

A combination of the pull-down resistor and the standby switching components is configured to reduce the open circuit breaker voltage. The Standby state uses the pull-down resistor together with the standby switching components. The On state uses the pull-down resistor together with the standby switching components. The On state, when the main power electronics components are On, the standby switching components are turned Off, as a result, no current can flow through the pull-down resistor. In the Standby state, when the main power electronics components are Off, the standby switching components are turned On, the pull-down resistor can lower a load side voltage.

In another embodiment, a Direct Current (DC) solid-state or semiconductor-based circuit breaker comprises an integral airgap in series with main power electronics components, at least one of a pull-down resistor or a pull-down resistance as a parasitic resistance and standby switching components placed in series with the pull-down resistor. The DC solid-state or semiconductor-based circuit breaker has an On state, an Off state, a Trip state and a Standby state. A combination of the pull-down resistor and the standby switching components is configured to reduce an open circuit breaker voltage. In the On state, when the main power electronics components are On, the standby switching components are turned Off, as a result, no current can flow through the pull-down resistor. In the Standby state, when the main power electronics components are Off, the standby switching components are turned On, the pull-down resistor can lower a load side voltage.

While a circuit and a method of reducing an open circuit breaker voltage of a Direct Current (DC) solid-state or semiconductor-based circuit breaker are disclosed. Other circuit schematics, components or building blocks may be implemented based on one or more features presented above without deviating from the spirit of the present disclosure.

The techniques described herein can be particularly useful for solid-state or semiconductor-based circuit breaker. While particular embodiments are described in terms of DC solid-state or semiconductor-based circuit breaker, the techniques described herein are not limited to such combination but can also be used with other combinations of components implemented in hardware or software.

While embodiments of the present disclosure have been disclosed in exemplary forms, it will be apparent to those skilled in the art that many modifications, additions, and deletions can be made therein without departing from the spirit and scope of the disclosure and its equivalents, as set forth in the following claims.

Embodiments and the various features and advantageous details thereof are explained more fully with reference to the non-limiting embodiments that are illustrated in the accompanying drawings and detailed in the following description. Descriptions of well-known starting materials, processing techniques, components and equipment are omitted so as not to unnecessarily obscure embodiments in detail. It should be understood, however, that the detailed description and the specific examples, while indicating preferred embodiments, are given by way of illustration only and not by way of limitation. Various substitutions, modifications, additions and/or rearrangements within the spirit and/or scope of the underlying inventive concept will become apparent to those skilled in the art from this disclosure.

As used herein, the terms "comprises," "comprising," "includes," "including," "has," "having" or any other variation thereof, are intended to cover a non-exclusive inclusion. For example, a process, article, or apparatus that comprises a list of elements is not necessarily limited to only those elements but may include other elements not expressly listed or inherent to such process, article, or apparatus.

Additionally, any examples or illustrations given herein are not to be regarded in any way as restrictions on, limits to, or express definitions of, any term or terms with which they are utilized. Instead, these examples or illustrations are to be regarded as being described with respect to one particular embodiment and as illustrative only. Those of ordinary skill in the art will appreciate that any term or terms with which these examples or illustrations are utilized will encompass other embodiments which may or may not be given therewith or elsewhere in the specification and all such embodiments are intended to be included within the scope of that term or terms.

In the foregoing specification, the disclosure has been described with reference to specific embodiments. However, one of ordinary skill in the art appreciates that various modifications and changes can be made without departing from the scope of the disclosure. Accordingly, the specification and figures are to be regarded in an illustrative rather than a restrictive sense, and all such modifications are intended to be included within the scope of disclosure.

Although the disclosure has been described with respect to specific embodiments thereof, these embodiments are merely illustrative, and not restrictive of the disclosure. The description herein of illustrated embodiments of the disclosure is not intended to be exhaustive or to limit the disclosure to the precise forms disclosed herein (and in particular, the inclusion of any particular embodiment, feature or function is not intended to limit the scope of the disclosure to such embodiment, feature or function). Rather, the description is intended to describe illustrative embodiments, features and functions in order to provide a person of ordinary skill in the art context to understand the disclosure without limiting the disclosure to any particularly described embodiment, feature or function. While specific embodiments of, and examples for, the disclosure are described herein for illustrative purposes only, various equivalent modifications are possible within the spirit and scope of the disclosure, as those skilled in the relevant art will recognize and appreciate. As indicated, these modifications may be made to the disclosure in light of the foregoing description of illustrated embodiments of the disclosure and are to be included within the spirit and scope of the disclosure. Thus, while the disclosure has been described herein with reference to particular embodiments thereof, a latitude of modification, various changes and substitutions are intended in the foregoing disclosures, and it will be appreciated that in some instances some features of embodiments of the disclosure will be employed without a corresponding use of other features without departing from the scope and spirit of the disclosure as set forth. Therefore, many modifications may be made to adapt a particular situation or material to the essential scope and spirit of the disclosure.

Respective appearances of the phrases "in one embodiment," "in an embodiment," or "in a specific embodiment" or similar terminology in various places throughout this specification are not necessarily referring to the same embodiment. Furthermore, the particular features, structures, or characteristics of any particular embodiment may be combined in any suitable manner with one or more other embodiments. It is to be understood that other variations and modifications of the embodiments described and illustrated herein are possible in light of the teachings herein and are to be considered as part of the spirit and scope of the disclosure.

In the description herein, numerous specific details are provided, such as examples of components and/or methods, to provide a thorough understanding of embodiments of the disclosure. One skilled in the relevant art will recognize, however, that an embodiment may be able to be practiced without one or more of the specific details, or with other apparatus, systems, assemblies, methods, components, materials, parts, and/or the like. In other instances, well-known structures, components, systems, materials, or operations are not specifically shown or described in detail to avoid obscuring aspects of embodiments of the disclosure. While the disclosure may be illustrated by using a particular embodiment, this is not and does not limit the disclosure to any particular embodiment and a person of ordinary skill in the art will recognize that additional embodiments are readily understandable and are a part of this disclosure.

It will also be appreciated that one or more of the elements depicted in the drawings/figures can also be implemented in a more separated or integrated manner, or even removed or rendered as inoperable in certain cases, as is useful in accordance with a particular application.

Benefits, other advantages, and solutions to problems have been described above with regard to specific embodiments. However, the benefits, advantages, solutions to problems, and any component(s) that may cause any benefit, advantage, or solution to occur or become more pronounced are not to be construed as a critical, required, or essential feature or component.

### FURTHER EMBODIMENTS:

1. A Direct Current (DC) solid-state or semiconductor-based circuit breaker, the DC solid-state or semiconductor-based circuit breaker comprising:
   an integral airgap in series with main power electronics components;
   at least one of a pull-down resistor or a pull-down resistance as a parasitic resistance being an unwanted resistance or an unintended resistance that exists within electronic components and circuits due to their physical properties and construction;
   standby switching components, including at least one of semiconductor components, relays or mechanical devices, placed in series with the pull-down resistor,
   wherein the DC solid-state or semiconductor-based circuit breaker having four possible states of operation including an On state, an Off state, a Trip state and a Standby state,
   wherein a combination of the pull-down resistor and the standby switching components is configured to reduce an open circuit breaker voltage, wherein the Standby state and the On state use the pull-down resistor together with the standby switching components,
   wherein in the On state, when the main power electronics components are On, the standby switching components are turned Off, as a result, no current can flow through the pull-down resistor, and wherein in the Standby state, when the main power electronics components are Off, the standby switching components are turned On, the pull-down resistor can lower a load side voltage.
2. The Direct Current (DC) solid-state or semiconductor-based circuit breaker of embodiment 1, wherein the On state is when the integral airgap is closed and the main power electronics components are turned On, and current flows to loads, wherein by adding the standby switching components and controlling them accordingly, the Direct Current (DC) solid-state or semiconductor-based circuit breaker can avoid power loss at the On state but still achieve a safe load side voltage, and wherein the parasitic resistance is caused by resistance of a supply source and/or an internal resistance of components like capacitors, inductors, and transistors and/or resistance of wires, and/or resistance of traces on a printed circuit board (PCB).
3. The Direct Current (DC) solid-state or semiconductor-based circuit breaker of embodiment 2, wherein the Off state is when the integral airgap is open and the main power electronics components are turned Off no current flows, and isolation is achieved.
4. The Direct Current (DC) solid-state or semiconductor-based circuit breaker of embodiment 3, wherein the Standby state is when the integral airgap is closed, and power electronics are turned Off such as in the Standby state, a load current is turned Off and the Direct Current (DC) solid-state or semiconductor-based circuit breaker is highly controllable as the load current can be turned On/Off by simply a toggle power electronics gate signal, wherein in the Standby state when the main power electronics components are Off, the standby switching components are turned On, and the pull-down resistor can allow an already charged capacitor to discharge.
5. The Direct Current (DC) solid-state or semiconductor-based circuit breaker of embodiment 1, wherein in the Standby state the main power electronics components are acting like resistors such that when a voltage is applied across them then small amounts of current is allowed to flow as a leakage current, and wherein many industry standards have limits for the leakage current, so they don't reach a harmful level, however, in a DC distribution network, one or more capacitors are used as a part of loads.
6. The Direct Current (DC) solid-state or semiconductor-based circuit breaker of embodiment 5, wherein even if the leakage current is small, a capacitor can still be charged up and create a high voltage at a load side of the Direct Current (DC) solid-state or semiconductor-based circuit breaker such that lowering of the load side voltage to a safe level is needed to not allow the capacitor to charge and a way of lowering the load side voltage is to have the pull-down resistor between the load side and a common, and wherein the leakage current can go through the pull-down resistor and lower the load side voltage.
7. The Direct Current (DC) solid-state or semiconductor-based circuit breaker of embodiment 6, wherein a significant drawback is that in the On state a system voltage is directly across the pull-down resistor and can create a lot of power loss so this solution provides a way to lower the load side voltage at the Standby state without increasing the On state power loss.
8. The Direct Current (DC) solid-state or semiconductor-based circuit breaker of embodiment 1, wherein the standby switching components are electronic components such as metal-oxide-semiconductor field-effect transistors (MOSFETs) which control conductivity, or how much electricity can flow, between its source and drain terminals based on an amount of voltage applied to its gate terminal and are used as switches and amplifiers in an electronic circuit, however, they can be mechanical switches as well.
9. A method to reduce an open circuit breaker voltage of a Direct Current (DC) solid-state or semiconductor-based circuit breaker, the method comprising:
   providing an integral airgap in series with main power electronics components;
   providing at least one of a pull-down resistor or a pull-down resistance as a parasitic resistance being an unwanted resistance or an unintended resistance that exists within electronic components and circuits due to their physical properties and construction;
   providing standby switching components, including at least one of semiconductor components, relays or mechanical devices, placed in series with the pull-down resistor,
   wherein the DC solid-state or semiconductor-based circuit breaker having four possible states of operation including an On state, an Off state, a Trip state and a Standby state,
   wherein a combination of the pull-down resistor and the standby switching components is configured to reduce the open circuit breaker voltage, wherein the Standby state and the On state use the pull-down resistor together with the standby switching components,
   wherein in the On state, when the main power electronics components are On, the standby switching components are turned Off, as a result, no current can flow through the pull-down resistor, and wherein in the Standby state, when the main power electronics components are Off, the standby switching components are turned On, the pull-down resistor can lower a load side voltage, and wherein the parasitic resistance is caused by resistance of a supply source and/or an internal resistance of components like capacitors, inductors, and transistors and/or resistance of wires, and/or resistance of traces on a printed circuit board (PCB).
10. The method of embodiment 9, wherein the On state is when the integral airgap is closed and the main power electronics components are turned On, and current flows to loads, wherein by adding the standby switching components and controlling them accordingly, the Direct Current (DC) solid-state or semiconductor-based circuit breaker can avoid power loss at the On state but still achieve a safe load side voltage.
11. The method of embodiment 10, wherein the Off state is when the integral airgap is open and the main power electronics components are turned Off no current flows, and isolation is achieved.
12. The method of embodiment 11, wherein the Standby state is when the integral airgap is closed, and power electronics are turned Off such as in the Standby state, a load current is turned Off and the Direct Current (DC) solid-state or semiconductor-based circuit breaker is highly controllable as the load current can be turned On/Off by simply a toggle power electronics gate signal, wherein in the Standby state when the main power electronics components are Off, the standby switching components are turned On, and the pull-down resistor can allow an already charged capacitor to discharge.
13. The method of embodiment 9, wherein in the Standby state the main power electronics components are acting like resistors such that when a voltage is applied across them then small amounts of current is allowed to flow as a leakage current, and wherein many industry standards have limits for the leakage current, so they don't reach a harmful level, however, in a DC distribution network, one or more capacitors are used as a part of loads.
14. The method of embodiment 13, wherein even if the leakage current is small, a capacitor can still be charged up and create a high voltage at a load side of the Direct Current (DC) solid-state or semiconductor-based circuit breaker such that lowering of the load side voltage to a safe level is needed to not allow the capacitor to charge and a way of lowering the load side voltage is to have the pull-down resistor between the load side and a common, and wherein the leakage current can go through the pull-down resistor and lower the load side voltage.
15. The method of embodiment 14, wherein a significant drawback is that in the On state a system voltage is directly across the pull-down resistor and can create a lot of power loss so this solution provides a way to lower the load side voltage at the Standby state without increasing the On state power loss.
16. The method of embodiment 9, wherein the standby switching components are electronic components such as metal-oxide-semiconductor field-effect transistors (MOSFETs) which control conductivity, or how much electricity can flow, between its source and drain terminals based on an amount of voltage applied to its gate terminal and are used as switches and amplifiers in an electronic circuit, however, they can be mechanical switches as well.
17. A Direct Current (DC) solid-state or semiconductor-based circuit breaker, the DC solid-state or semiconductor-based circuit breaker comprising:
   an integral airgap in series with main power electronics components;
   at least one of a pull-down resistor or a pull-down resistance as a parasitic resistance;
   standby switching components placed in series with the pull-down resistor, wherein the DC solid-state or semiconductor-based circuit breaker having an On state, an Off state, a Trip state and a Standby state, wherein a combination of the pull-down resistor and the standby switching components is configured to reduce an open circuit breaker voltage,
   wherein in the On state, when the main power electronics components are On, the standby switching components are turned Off, as a result, no current can flow through the pull-down resistor, and wherein in the Standby state, when the main power electronics components are Off, the standby switching components are turned On, the pull-down resistor can lower a load side voltage.
18. The Direct Current (DC) solid-state or semiconductor-based circuit breaker of embodiment 17, wherein the On state is when the integral airgap is closed and the main power electronics components are turned On, and current flows to loads, wherein by adding the standby switching components and controlling them accordingly, the Direct Current (DC) solid-state or semiconductor-based circuit breaker can avoid power loss at the On state but still achieve a safe load side voltage, and wherein the parasitic resistance is caused by resistance of a supply source and/or an internal resistance of components like capacitors, inductors, and transistors and/or resistance of wires, and/or resistance of traces on a printed circuit board (PCB).
19. The Direct Current (DC) solid-state or semiconductor-based circuit breaker of embodiment 18, wherein the Off state is when the integral airgap is open and the main power electronics components are turned Off no current flows, and isolation is achieved.
20. The Direct Current (DC) solid-state or semiconductor-based circuit breaker of embodiment 19, wherein the Standby state is when the integral airgap is closed, and power electronics are turned Off such as in the Standby state, a load current is turned Off and the Direct Current (DC) solid-state or semiconductor-based circuit breaker is highly controllable as the load current can be turned On/Off by simply a toggle power electronics gate signal, wherein in the Standby state when the main power electronics components are Off, the standby switching components are turned On, and the pull-down resistor can allow an already charged capacitor to discharge.

## Claims

1. A direct current -DC- solid-state or semiconductor-based circuit breaker, the DC circuit breaker comprising:
an integral airgap in series with main power electronics components;
at least one of a pull-down resistor or a pull-down resistance as a parasitic resistance;
standby switching components placed in series with the pull-down resistor, wherein the DC solid-state or semiconductor-based circuit breaker having an On state, an Off state, a Trip state and a Standby state, wherein a combination of the pull-down resistor and the standby switching components is configured to reduce an open circuit breaker voltage,
wherein in the On state, when the main power electronics components are On, the standby switching components are turned Off, as a result, no current can flow through the pull-down resistor, and wherein in the Standby state, when the main power electronics components are Off, the standby switching components are turned On, the pull-down resistor can lower a load side voltage.

2. The DC cicuit breaker of claim 1,
wherein the at least one of a pull-down resistor or a pull-down resistance as a parasitic resistance being an unwanted resistance or an unintended resistance that exists within electronic components and circuits due to their physical properties and construction;
wherein the standby switching components include at least one of semiconductor components, relays or mechanical devices,
wherein the DC circuit breaker having four possible states of operation including the On state, the Off state, the Trip state and the Standby state,
wherein a combination of the pull-down resistor and the standby switching components is configured to reduce an open circuit breaker voltage, wherein the Standby state and the On state use the pull-down resistor together with the standby switching components.

3. The circuit breaker of claim 2, wherein the On state is when the integral airgap is closed and the main power electronics components are turned On, and current flows to loads, wherein by adding the standby switching components and controlling them accordingly, the circuit breaker can avoid power loss at the On state but still achieve a safe load side voltage, and wherein the parasitic resistance is caused by resistance of a supply source and/or an internal resistance of components like capacitors, inductors, and transistors and/or resistance of wires, and/or resistance of traces on a printed circuit board -PCB-.

4. The circuit breaker according to any of the preceding claims, wherein the Off state is when the integral airgap is open and the main power electronics components are turned Off no current flows, and isolation is achieved.

5. The circuit breaker according to any of the preceding claims , wherein the Standby state is when the integral airgap is closed, and power electronics are turned Off such as in the Standby state, a load current is turned Off and the circuit breaker is highly controllable as the load current can be turned On/Off by simply a toggle power electronics gate signal, wherein in the Standby state when the main power electronics components are Off, the standby switching components are turned On, and the pull-down resistor can allow an already charged capacitor to discharge.

6. The circuit breaker according to any of the preceding claims , wherein in the Standby state the main power electronics components are acting like resistors such that when a voltage is applied across them then small amounts of current is allowed to flow as a leakage current, and wherein many industry standards have limits for the leakage current, so they don't reach a harmful level, however, in a DC distribution network, one or more capacitors are used as a part of loads.

7. The circuit breaker of claim 6, wherein even if the leakage current is small, a capacitor can still be charged up and create a high voltage at a load side of the circuit breaker such that lowering of the load side voltage to a safe level is needed to not allow the capacitor to charge and a way of lowering the load side voltage is to have the pull-down resistor between the load side and a common, and wherein the leakage current can go through the pull-down resistor and lower the load side voltage.

8. The circuit breaker of claim 6 or 7, wherein a significant drawback is that in the On state a system voltage is directly across the pull-down resistor and can create a lot of power loss so this solution provides a way to lower the load side voltage at the Standby state without increasing the On state power loss.

9. The circuit breaker according to any of the preceding claims, wherein the standby switching components are electronic components such as metal-oxide-semiconductor field-effect transistors -MOSFETs- which control conductivity, or how much electricity can flow, between its source and drain terminals based on an amount of voltage applied to its gate terminal and are used as switches and amplifiers in an electronic circuit, however, they can be mechanical switches as well.

10. A method to reduce an open circuit breaker voltage of a Direct Current -DC- solid-state or semiconductor-based circuit breaker, in particular of a DC circuit breaker according to any of the preceding claims, the method comprising:
providing an integral airgap in series with main power electronics components;
providing at least one of a pull-down resistor or a pull-down resistance as a parasitic resistance being an unwanted resistance or an unintended resistance that exists within electronic components and circuits due to their physical properties and construction;
providing standby switching components, including at least one of semiconductor components, relays or mechanical devices, placed in series with the pull-down resistor,
wherein the DC solid-state or semiconductor-based circuit breaker having four possible states of operation including an On state, an Off state, a Trip state and a Standby state,
wherein a combination of the pull-down resistor and the standby switching components is configured to reduce the open circuit breaker voltage, wherein the Standby state and the On state use the pull-down resistor together with the standby switching components,
wherein in the On state, when the main power electronics components are On, the standby switching components are turned Off, as a result, no current can flow through the pull-down resistor, and wherein in the Standby state, when the main power electronics components are Off, the standby switching components are turned On, the pull-down resistor can lower a load side voltage, and wherein the parasitic resistance is caused by resistance of a supply source and/or an internal resistance of components like capacitors, inductors, and transistors and/or resistance of wires, and/or resistance of traces on a printed circuit board -PCB-.

11. The method of claim 10, wherein the On state is when the integral airgap is closed and the main power electronics components are turned On, and current flows to loads, wherein by adding the standby switching components and controlling them accordingly, the Direct Current (DC) solid-state or semiconductor-based circuit breaker can avoid power loss at the On state but still achieve a safe load side voltage.

12. The method of claim 10 or 11, wherein the Off state is when the integral airgap is open and the main power electronics components are turned Off no current flows, and isolation is achieved, in particular wherein the Standby state is when the integral airgap is closed, and power electronics are turned Off such as in the Standby state, a load current is turned Off and the Direct Current (DC) solid-state or semiconductor-based circuit breaker is highly controllable as the load current can be turned On/Off by simply a toggle power electronics gate signal, wherein in the Standby state when the main power electronics components are Off, the standby switching components are turned On, and the pull-down resistor can allow an already charged capacitor to discharge.

13. The method according to any of the claims 10 to 12, wherein in the Standby state the main power electronics components are acting like resistors such that when a voltage is applied across them then small amounts of current is allowed to flow as a leakage current, and wherein many industry standards have limits for the leakage current, so they don't reach a harmful level, however, in a DC distribution network, one or more capacitors are used as a part of loads

14. The method of claim 13, wherein even if the leakage current is small, a capacitor can still be charged up and create a high voltage at a load side of the Direct Current (DC) solid-state or semiconductor-based circuit breaker such that lowering of the load side voltage to a safe level is needed to not allow the capacitor to charge and a way of lowering the load side voltage is to have the pull-down resistor between the load side and a common, and wherein the leakage current can go through the pull-down resistor and lower the load side voltage, in particular wherein a significant drawback is that in the On state a system voltage is directly across the pull-down resistor and can create a lot of power loss so this solution provides a way to lower the load side voltage at the Standby state without increasing the On state power loss.

15. The method according to any of the claims 10 to 14, wherein the standby switching components are electronic components such as metal-oxide-semiconductor field-effect transistors (MOSFETs) which control conductivity, or how much electricity can flow, between its source and drain terminals based on an amount of voltage applied to its gate terminal and are used as switches and amplifiers in an electronic circuit, however, they can be mechanical switches as well.
